(19) Europäisches Patentamt
European Patent Office
Office européen des brevets

(11) **EP 4 131 721 A1**

(12) **EUROPEAN PATENT APPLICATION**
published in accordance with Art. 153(4) EPC

(43) Date of publication:
**08.02.2023 Bulletin 2023/06**

(21) Application number: **22773582.6**

(22) Date of filing: **22.02.2022**

(51) International Patent Classification (IPC):
*H02J 50/00* (2016.01)  *B62K 15/00* (1968.09)
*H01Q 1/02* (1968.09)  *H02J 50/10* (2016.01)
*H02J 7/02* (1968.09)  *H05K 7/20* (1968.09)

(52) Cooperative Patent Classification (CPC):
**B60L 53/12; H02J 50/00; H02J 50/12; H02J 50/20;
H05K 7/20**

(86) International application number:
**PCT/KR2022/002575**

(87) International publication number:
**WO 2022/255595 (08.12.2022 Gazette 2022/49)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **01.06.2021 KR 20210071090**

(71) Applicant: SKC Co., Ltd.
**Suwon-si, Gyeonggi-do 16336 (KR)**

(72) Inventors:
• KIM, Nah Young
  **Suwon-si, Gyeonggi-do 16338 (KR)**
• LEE, Seung Hwan
  **Suwon-si, Gyeonggi-do 16338 (KR)**
• CHOI, Jong Hak
  **Suwon-si, Gyeonggi-do 16338 (KR)**
• KIM, Tae Kyoung
  **Suwon-si, Gyeonggi-do 16338 (KR)**

(74) Representative: **Stolmár & Partner
Patentanwälte PartG mbB
Blumenstraße 17
80331 München (DE)**

(54) **WIRELESS CHARGING DEVICE AND ELECTRIC MOBILE DEVICE HAVING SAME**

(57)  A wireless charging apparatus of the present invention includes a heat radiation module, a circuit board disposed in the heat radiation module, and a power module disposed in the heat radiation module and having a coil for wireless charging, wherein the heat radiation module includes a case body in which the circuit board and the power module are housed, and a partition part formed inside the case body to form a separation space between the circuit board and the power module.

[FIG. 5]

**Description**

[BACKGROUND OF THE INVENTION]

1. Field of the Invention

The present invention relates to a wireless charging apparatus and an electric vehicle having the same, and more particularly, to a wireless charging apparatus having an improved structure and an electric vehicle including the wireless charging apparatus.

2. Description of the Related Art

In general, a wireless charging method is a method for charging a battery using electromagnetic induction, and is a method in which a wireless charger (wireless power transmission apparatus) is provided with a primary coil (transmission coil) and an electronic device to be charged (wireless power reception apparatus) is provided with a secondary coil (reception coil), such that a current generated by magnetic induction method between the primary coil and the secondary coil is converted into an electrical energy to charge the battery.

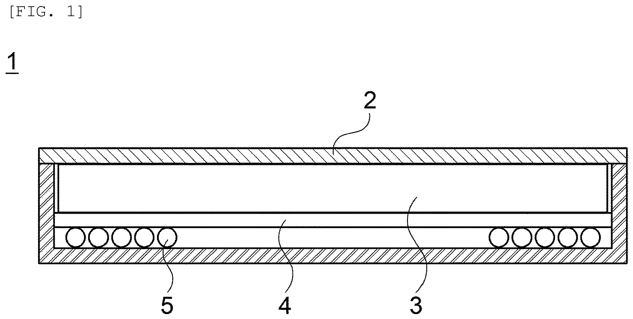

As shown in FIG. 1, a conventional wireless charging apparatus 1, that is, the wireless power transmission apparatus or wireless power reception apparatus, includes a case 2, a circuit board 3, a magnetic member 4, and a coil 5. The circuit board 3, the magnetic member 4, and the coil 5 are disposed inside the case 2.

During performing wireless charging of the electronic device through the above-described wireless charging apparatus, a lot of heat is generated from the coil and the circuit board of the wireless charging apparatus.

As such, it is necessary for the coil and the circuit board to radiate the heat to an outside through a shielding plate or heat radiation plate. However, there is a problem in that the heat remains inside the case or is transferred between the coil and the circuit board, such that heat radiation efficiency is significantly reduced.

When such a control of heat generation is not effectively performed, due to heat generation of the electronic device or the wireless charging apparatus, user's inconvenience and a reduction in life-span of the device itself may be caused.

In addition, as the wireless charging method has been commercialized in recent years, a high-output wireless charging apparatus capable of improving wireless charging efficiency is required. However, when the output of the wireless charging apparatus is increased, there is an effect of increasing the charging speed, but the heat generation is also increased by that amount. Therefore, research for effectively dissipating the heat generated from the wireless charging apparatus is required.

[SUMMARY OF THE INVENTION]

An object of the present invention is to provide a wireless charging apparatus having an improved structure, and an electric vehicle having the same.

In addition, another object of the present invention is to provide a wireless charging apparatus having improved heat radiation efficiency, and an electric vehicle having the same.

Further, another object of the present invention is to provide a wireless charging apparatus having improved durability and sealing properties, and an electric vehicle having the same.

To achieve the above objects, according to an aspect of the present invention, there is provided a wireless charging apparatus including: a heat radiation module; a circuit board disposed in the heat radiation module; and a power module which is disposed in the heat radiation module and includes a coil for wireless charging, wherein the heat radiation module includes: a case body in which the circuit board and the power module are housed; and a partition part formed inside the case body to form a separation space between the circuit board and the power module.

The heat radiation module may include a first space in which the circuit board is disposed, and a second space in which the power module is disposed, wherein the partition part may be configured to partition the first and second spaces.

The partition part may include: a partition plate connected to an inner surface of the case body; and at least one heat radiation fin protruding from the partition plate to the circuit board or the power module, wherein the separation space may be formed in a direction in which the heat radiation fin protrudes.

The partition part may include first and second partition plates connected to an inner surface of the case body and formed to be spaced apart from each other, wherein the separation space may be formed between the first partition plate and the second partition plate.

The case body of the heat radiation module and the partition part may be integrally formed with each other.

The heat radiation module may include external heat radiation fins extending outwardly from the case body and formed in a radial direction.

The external heat radiation fins may include a plurality of mounting heat radiation fins having different protrusion heights from the case body so as to have a shape corresponding to the shape of an installation surface which is mounted on the heat radiation module.

In addition, according to another aspect of the present invention, there is provided an electric vehicle configured to move using electricity as a power source, including: a wireless charging apparatus; and a battery configured to be charged through the wireless charging apparatus, the wireless charging apparatus comprises: a heat radiation module; a circuit board disposed in the heat radiation module; and a power module which is disposed in the heat radiation module and includes a coil for wireless charging, wherein the heat radiation module comprises: a case body in which the circuit board and the power module are housed; and a partition part formed inside the case body to form a separation space between the circuit board and the power module.

Further, according to another aspect of the present invention, there is provided a wireless charging apparatus including: a heat radiation module; a circuit board disposed in the heat radiation module; and a power module which is disposed in the heat radiation module and includes a coil for wireless charging, wherein a heating rate (HR, °C/min) expressed by Equation below is greater than 0 and less than 2.0:

$$\text{Heating rate (HR)} = \Delta \text{ Heating temperature (℃)} / 60 \text{ min}$$

(In the above equation, the 60 min is a time for which the wireless charging apparatus is charged, and the Δ heating temperature means a temperature change when the wireless charging apparatus is charged for 60 minutes).

The heat radiation module may include: a case body in which the circuit board and the power module are housed; and a partition part formed inside the case body to form a separation space between the circuit board and the power module.

According to an aspect of the present invention, it is possible to improve the heat radiation efficiency of the wireless charging apparatus by enhancing the heat radiation structure.

In addition, according to another aspect of the present invention, it is possible to minimize heat from remaining inside the apparatus and maximize heat radiation to an outside by minimizing heat transfer between the coil and the circuit board such as a PCB.

Further, according to another aspect of the present invention, the case and the partition part, or the case and the partition part and the external heat radiation fins are formed as one module, such that sealing properties and sealing efficiency of the wireless charging apparatus may be improved.

[BRIEF DESCRIPTION OF THE DRAWINGS]

The above and other objects, features and other advantages of the present invention will be more clearly understood from the following detailed description taken in conjunction with the accompanying drawings, in which:

FIG. 1 is a view of a conventional wireless charging apparatus;
FIG. 2 is a perspective view of an electric vehicle according to an embodiment of the present invention;
FIG. 3 is a front view of the electric vehicle according to an embodiment of the present invention;
FIG. 4 is a perspective view of a wireless charging apparatus according to an embodiment of the present invention;
FIG. 5 is a cross-sectional view of the wireless charging apparatus according to an embodiment of the present invention;
FIG. 6 is a graph illustrating heating temperatures over time of the wireless charging apparatus according to an embodiment of the present invention and the conventional wireless charging apparatus;
FIG. 7 is a cross-sectional view of a wireless charging apparatus according to another embodiment of the present invention; and
FIG. 8 is a cross-sectional view of a wireless charging apparatus according to another embodiment of the present invention.

[DETAILED DESCRIPTION OF THE INVENTION]

Configurations illustrated in the embodiments and drawings of the present disclosure are only preferred examples of the invention, and diverse modifications capable of replacing the embodiments and drawings of the present disclosure may be possible at a time of filing the present application.

Further, the same reference numerals or symbols in the drawings of the present disclosure will represent parts or components having substantially the same functions.

In addition, the terminology used herein is for the purpose of describing particular embodiments only and is not intended to limit the present invention thereto. As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, integers, steps, operations, elements, and/or components, but do not preclude the presence or addition of one or more other features, integers, steps, operations, elements, components, and/or groups thereof.

Further, the terms including numerals such as "first," "second," etc. in the present disclosure may be used to describe different components, but such components are not limited thereto. These terms are used only to distinguish one component from other components. For example, a first component may also be named a second component without departing from the scope of the present invention. Likewise, the second component may also be named the first component. The term "and/or" may include a combination of a plurality of related items and/or any one among the plurality of related items.

In addition, the terms such as a "part," "device," "block," "member," "module," and the like may refer to a unit to execute at least one function or operation. For example, the terms may refer to at least one hardware such as a field-programmable gate array (FPGA) or an application specific integrated circuit (ASIC), at least one operating process performed by at least one software stored in a memory or processor.

Hereinafter, preferred embodiments of the present invention will be described in detail with reference to the accompanying drawings. However, since the drawings attached to the present disclosure are only given for illustrating one of several preferred embodiments of present invention to easily understand the technical spirit of the present invention with the above-described invention, it should not be construed as limited to such a description illustrated in the drawings.

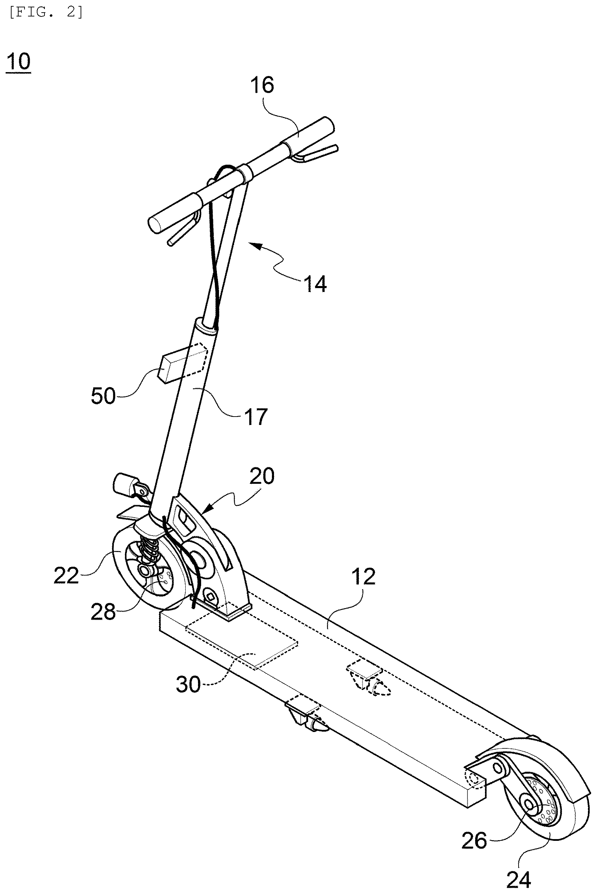

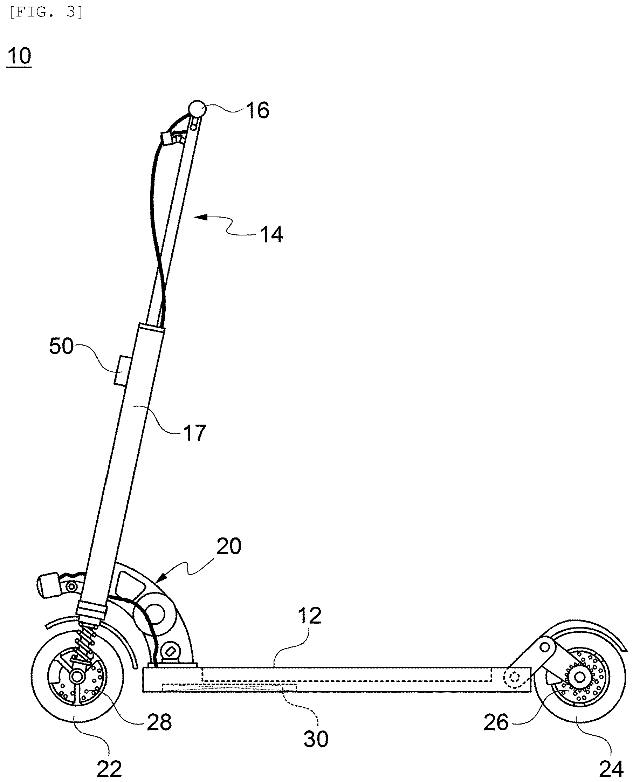

FIG. 2 is a perspective view of an electric vehicle according to an embodiment of the present invention, and FIG. 3 is a front view of the electric vehicle according to an embodiment of the present invention

The electric vehicle may refer to an apparatus configured to be movable using electricity as a power source. The electric vehicle may include an electric scooter, an electric automobile, an electric wheel, an electric bicycle, an electric motorcycle, an electric vehicle with two parallel wheels, a robot cleaner and the like. In the present embodiment, the case in which the electric vehicle is an electric scooter 10 as shown in FIGS. 2 and 3 has been described as an example, but it is not limited thereto.

The electric scooter 10 may include a deck body 12 and a steering unit 14.

The deck body 12 may serve to provide a support surface for allowing a user to ride. In addition, the design of the deck body 12 may be altered in a form of a mobile structure for implementing the function of smart mobility. In this case, the deck body may refer to a main body for the electric wheel, electric bicycle, or electric bicycle.

In addition, the deck body 12 is a footrest on which the user may ride by raising his or her feet. The deck body 12 may be manufactured as a deck-type structure on which the user stands and rides. Alternatively, although not shown in the drawings, the deck body 12 may be configured as a seat-type structure by further including a seat part on an upper surface thereof. Or otherwise, although not shown in the drawings, the deck body 12 may be configured as a wheel-type structure by further including sole support parts on sides of the wheel. However, the deck body 12 is not limited to a specific structure.

The steering unit 14 may be rotatably coupled to a front end of the deck body 12 to perform a steering function. The steering unit 14 may include a handlebar 16 on which a brake lever and a shift lever are mounted, and a steering tube 17 for supporting the handlebar 16 to be rotated together therewith.

The steering unit 14 may be disposed at a distal (e.g., front) end of the deck body 12 to change a traveling direction of the deck body 12.

The electric scooter 10 may include a folding part 20.

The folding part 20 may be configured to connect the deck body 12 and the steering tube 17 of the steering unit 14. The folding part 20 may be configured so that the steering unit 14 is folded with respect to the deck body 12. Through the folding part 20, an external structure of the electric scooter 10 may be transformed into a compact form, thereby facilitating storage and transportation thereof.

The electric scooter 10 may include a front wheel 22, a rear wheel 24, a driving motor 26, and a brake 28.

The front wheel 22 may be installed at a lower end of the steering unit 14 in a manner of being rotatably supported at the lower end thereof below the above-described handlebar 16.

A steering angle of the front wheel 22 may be controlled by a steering operation of a user transmitted from the handlebar 16.

It may be understood that the front wheel 22 and the rear wheel 24 are collectively referred to respective components including a tire, a wheel frame, a bearing and the like.

The rear wheel 24 is a kind of driving wheel, which is installed at a rear end of the deck body 12 and is configured to be driven by the driving motor 26. A driving shaft of the driving motor 26 may coincide with a wheel frame and a wheel rotation shaft of the rear wheel 24 to have a configuration as a wheel integrated motor device.

The driving motor 26 may serve to drive the rear wheel 24. Since the separate driving motor 26 may also be mounted on the front wheel 22 through alternations in design, the mounting position of the driving motor 26 is not limited to a specific position. The driving motor 26 may referred to a general brushless direct current motor (BLDC) or a driving and regenerative braking type motor (e.g., an electric motor serving as a generator).

The brake 28 may also be mounted on either the front wheel 22 or the rear wheel 24, or may be mounted on each of the front wheel 22 and the rear wheel 24. The brake 28 may be a mechanical brake using friction or an electromagnetic brake. Herein, the electromagnetic brake refers to a regenerative braking or power regenerative brake, and may have a configuration in which, by using an inertial force generated when an electric motor (e.g., the driving motor 26 or an electric motor for a brake separately attached to the front wheel 22) moving with a torque force is in a closed circuit state, a rotor attached to the front wheel 22 or the rear wheel 24, etc. is rotated to allow the electric motor to be operated as a generator function, and thereby exhibiting a braking force by converting a kinetic energy into an electrical energy and recovering the same.

Such the brake 28 may serve to stop the front wheel 22 and the rear wheel 24 or to reduce the wheel rotation speed, and may also be used to perform a kick and go function in an inclined section or a cruise function in conjunction with a control unit (not illustrated) to be described below.

The battery 30 includes a plurality of battery cells connected with each other in parallel, and may refer to a rechargeable battery pack.

The battery 30 may serve to supply a power to the driving motor 26 and the control unit (not illustrated). In addition, the battery 30 may be used for the operation of electric and electronic components such as the electric scooter 10 as a power source.

The electric scooter 10 may include a wireless charging apparatus 50. The wireless charging apparatus 50 may be mounted on the steering tube 17 of the steering unit 14. The wireless charging apparatus 50 may be configured to wirelessly receive a power and supply it to the battery 30.

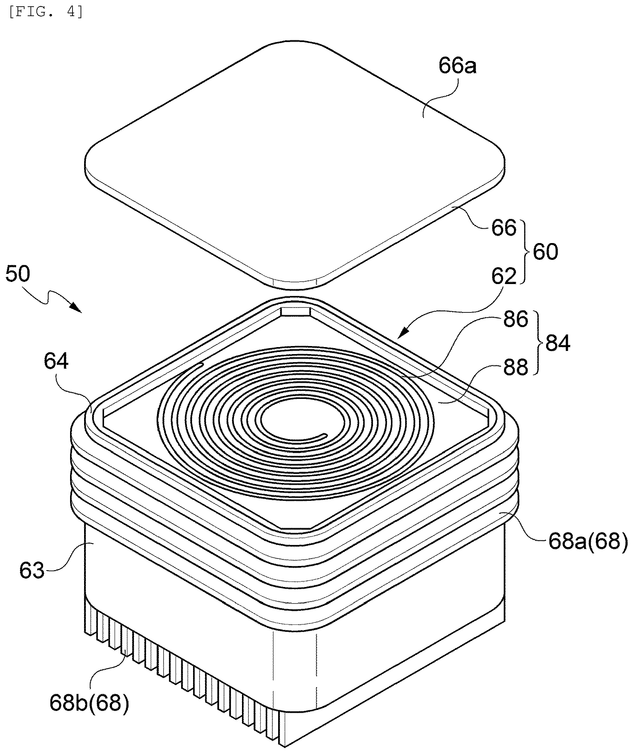

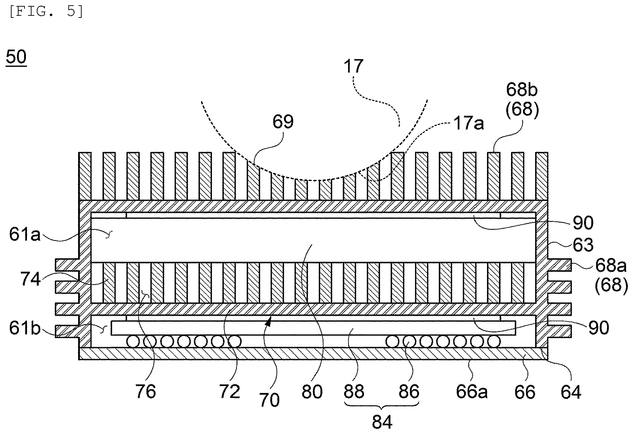

FIG. 4 is a perspective view of a wireless charging apparatus according to an embodiment of the present invention, and FIG. 5 is a cross-sectional view of the wireless charging apparatus according to an embodiment of the present invention.

The wireless charging apparatus 50 may include a power transmission apparatus for transmitting power and a power reception apparatus for receiving the power. The case in which the wireless charging apparatus 50 is the power reception apparatus disposed on the electric scooter 10 in FIGS. 2 and 3 has been described as an example, but it is not limited thereto. The wireless charging apparatus 50 may refer to a power transmission apparatus provided in a charging booth in which the electric vehicle is charged. That is, the wireless charging apparatus 50 of the present embodiment may refer to the power transmission apparatus provided in the charging booth (not illustrated) on which the electric scooter 10 is placed.

The wireless charging apparatus 50 may wirelessly receive the power by a magnetic induction method, a magnetic resonance method, or an electromagnetic wave method.

The wireless charging apparatus 50 may include a heat radiation case 60, a circuit board 80, and a power module 84.

The heat radiation case 60 may form an exterior of the wireless charging apparatus 50, and may be configured so that the circuit board 80 and the power module 84 are disposed therein, which will be described below.

The heat radiation case 60 may include a heat radiation module 62 and a case cover 66. The heat radiation module 62 may include a case body 63 and a partition part 70. In addition, the heat radiation module 62 may further include external heat radiation fins 68. The heat radiation case 60 will be described in detail below.

The power module 84 may include a coil part 86 and a magnetic member 88.

The coil part 86 may include a conductive wire.

The conductive wire included in the coil part 86 may include a conductive material. For example, the conductive wire may include conductive metal. Specifically, the conductive wire may include at least one metal selected from the group consisting of copper, nickel, gold, silver, zinc and tin.

In addition, the conductive wire may have an insulation shell. For example, the insulation shell may include an insulation polymer resin. Specifically, the insulation shell may include a polyvinyl chloride (PVC) resin, a polyethylene (PE) resin, a Teflon resin, a silicone resin, a polyurethane resin and the like.

The conductive wire may have a diameter, for example, in a range of 0.1 to 10 mm, in a range of 0.1 to 5 mm, or in a range of 0.1 to 3 mm.

The conductive wire may be wound in the form of a planar coil. Specifically, the planar coil may include a planar spiral coil. In this case, the shape of the planar coil may be an elliptical or polygonal shape, or a polygonal shape having rounded corners, but it is not particularly limited.

The planar coil may have an outer diameter of 2 to 20 cm, 3 to 12 cm, 3 to 10 cm, 5 to 16 cm, or 6 to 15 cm. As a specific example, the planar coil may have an outer diameter of 3 to 12 cm.

In addition, the planar coil may have an inner diameter of 0.5 to 10 cm, 1 to 8 cm, or 2 to 7 cm.

The number of windings of the planar coil may be 5 to 50 times, 7 to 30 times, 5 to 30 times, or 10 to 50 times.

As a specific example, the planar coil may be formed by winding the conductive wire 10 to 30 times.

Within the preferred planar coil dimension and specification range as described above, it may be suitable for a field such as an electric automobile, which requires large-capacity power transmission.

The magnetic member 88 may be configured to support one side of the coil part 86.

The magnetic member 88 may include a polymer type magnetic part including a binder resin and a filler. Specifically, the magnetic member 88 may include a polymer type magnetic part including the binder resin and a filler dispersed in the binder resin. The polymer type magnetic part may include a polymer type magnetic block (PMB). In the polymer type magnetic part, the fillers are combined with each other by the binder resin, such that damage due to impact may be decreased while reducing defects in a large area as a whole.

The magnetic member 88 may include ferrite. Specifically, the magnetic member 88 may include Ni-Zn-based ferrite, Mg-Zn-based ferrite, or Mn-Zn-based ferrite.

The circuit board 80 may be provided to control overall driving of the wireless charging apparatus 50. The circuit board 80 is provided to charge the battery 30 with an induced current generated through the coil part 86.

In the present embodiment, the case in which the wireless charging apparatus 50 is the power reception apparatus has been described as an example, but in the case in which the wireless charging apparatus 50 is the power transmission apparatus, the circuit board 80 converts AC power supplied from an outside into DC power, and converts it back to AC voltage of a specific frequency, then may supply it to the coil part 86 of the power module 84. In addition, when the DC power is directly supplied from the outside, the circuit board 80 converts the supplied DC power into AC voltage of a specific frequency, then may supply it to the coil part 86 of the power module 84. Through this, when the wireless charging apparatus 50 is the power transmission apparatus, current flows in the coil part 86 of the power module 84, thereby generating a magnetic field for generating an induced current.

The wireless charging apparatus 50 may include a heat transfer member 90. The heat transfer member 90 may be disposed on at least one side of the circuit board 80 and the power module 84. Specifically, the heat transfer member 90 may be disposed between the circuit board 80 and the inner surface of the case body 63 or the partition part 70, or between the power module 84 and the partition part 70.

Surfaces of the circuit board 80 and the power module 84 facing the heat radiation module 62 may not be flat, and may have a convex structure or a concave structure. The heat transfer member 90 is disposed between the surfaces of the circuit board 80 and the power module 84 which may be formed in the concave-convex structure as described above and the heat radiation module 62, thereby increasing a heat transfer area therebetween. That is, the heat transfer member 90 may increase the heat transfer area of the circuit board 80 or the power module 84 to the heat radiation module 62 through the arrangement as described above, and may improve the heat transfer efficiency.

The heat radiation case 60 may include the heat radiation module 62 and the case cover 66, as described above.

The heat radiation module 62 may be made of a heat radiation material. Components included in the heat radiation module 62 may be integrally formed with each other. The heat radiation module 62 may include the case body 63 and the partition part 70. In addition, the heat radiation module 62 may further include the external heat radiation fins 68. The heat radiation module 62 may be exposed to an outside so as to dissipate heat to the outside.

All of the case body 63 and the partition part 70 or the case body 63 and the partition part 70 and the external heat radiation fins 68 may be integrally formed with each other. However, it is not limited thereto, and at least one of the external heat radiation fins 68 and the partition part 70 may be detachably mounted to the case body 63. When the external heat radiation fins 68 are mounted on the case body 63 in a detachable manner, the external heat radiation fins 68 themselves may be mounted detachably from the case body 63. Alternatively, when the external heat radiation fins 68 may be integrally formed with a portion of the case body 63, the portion of the case body 63 may be mounted detachably from the other portion of the case body 63.

Since each of the case body 63, the partition part 70, and the external heat radiation fin 68 is one component of the heat radiation module, all of them may be made of a heat radiation material. The heat radiation material may include, for example, aluminum. However, the type of heat radiation material is not limited.

The case body 63 is configured to be exposed to the outside, and thereby the heat generated from the circuit board 80 and the power module 84 disposed therein may be configured to radiate to the outside. Through this, the heat radiation module 62 itself may perform both functions of housing and cooling the components.

The external heat radiation fins 68 may be configured to protrude from the case body 63 in a radial direction as shown in FIG. 5. The external heat radiation fins 68 may be one component of the case body 63. In addition, the external heat radiation fins 68 may be integrally formed with the case body 63. The external heat radiation fins 68 may be configured to protrude from the case body 63 to exchange heat with external air. The external heat radiation fins 68 may expand the exposed area of the heat radiation module 62 to an external space, thereby improving the heat radiation efficiency. The number of external heat radiation fins 68 is not limited, and may be applied differently in consideration of the size, arrangement, and required heat radiation amount of the heat radiation module 62.

The external heat radiation fins 68 may include first external heat radiation fins 68a protruding in the radial direction from a side of the case body 63 and second external heat radiation fins 68b protruding in a longitudinal direction (e.g., to the rear) of the case body 63. In the present disclosure, the front may refer to a direction in which the case body 63 faces a charging surface 66a, and the rear may refer to a direction opposite thereto.

The second external heat radiation fins 68b may include a mounting part 69 to be mounted on a required mounting surface of the electric vehicle. The mounting part 69 may be formed on the second external heat radiation fins 68b as shown in FIG. 5. Specifically, the second external heat radiation fins 68b may have different heights protruding from the case body 63 so as to have a shape corresponding to the required mounting surface of the electric vehicle as a whole, and the mounting part 69 may be formed through the above-described configuration. The mounting part 69 may be formed in a concave shape to correspond to the mounting surface 17a of the steering tube 17 of the electric scooter 10 as shown in FIG. 5, or may be formed to correspond to the shape of the corresponding mounting surface of the electric vehicle. In FIG. 5, the mounting surface 17a of the steering tube 17 is formed in a curved surface, and the mounting part 69 is formed in the concave shape to correspond thereto, but it is not limited thereto. As an example, the mounting surface 17a may be formed in a polygonal or elliptical shape, or curved surface, and the mounting part 69 may be formed in a shape corresponding thereto. As such, the second external heat radiation fins 68b on which the mounting part 69 is formed may be defined as the mounting heat radiation fins.

The mounting part 69 may be spaced apart from the case body 63 by the second external heat radiation fins 68b. Thereby, even when the wireless charging apparatus 50 is mounted on the electric vehicle, it is possible to maximally secure the heat radiation area, and prevent the heat radiation area of the heat radiation case 60 from being reduced while the heat radiation case 60 is mounted on the electric vehicle.

The heat radiation module 62 may include the partition part 70. The partition part 70 may be disposed inside the case body 63, and may be configured to partition a space formed inside the case body 63. The partition part 70 is one component of the heat radiation module 62, may be made of a heat radiation material, and may include an aluminum material, for example. The partition part 70 may be configured to transfer heat received from the circuit board 80 or the power module 84 to the case body 63.

The partition part 70 may be configured to partition the inside of the case body 63 so as to prevent the heat generated from the circuit board 80 and the power module 84 from being transferred therebetween. The partition part 70 may be integrally formed with the case body 63 so that the partition part 70 allows the received heat to be transferred to the case body 63.

The partition part 70 may include a partition plate 72 and heat radiation fins 74.

The partition plate 72 may be configured to partition a first space 61a in which the circuit board 80 is disposed and a second space 61b in which the power module 84 is disposed. In the wireless charging apparatus 50, the case cover 66 having the charging surface 66a formed therein, the power module 84, and the circuit board 80 may be arranged in this order in one direction (e.g., an up-to-down direction in Fig.5), and the partition plate 72 may be formed in a direction different from the one direction, for example, a direction perpendicular thereto (e.g., a left-to-right direction in Fig.5), to partition the power module 84 and the circuit board 80.

The partition plate 72 may be connected to an inner surface of the case body 63 along an inner circumference thereof. Thereby, it is possible to prevent convection due to heat from occurring between the first and second spaces 61a and 62a, and control heat radiation in each of the first and second spaces 61a and 62a in which the circuit board 80 and the power module 84 are disposed, respectively.

The heat radiation fins 74 may be disposed on the partition plate 72. The heat radiation fins 74 are disposed on the partition plate 72, and may be configured to extend in one direction. The one direction is the above-described direction in which the case cover 66, the power module 84, and the circuit board 80 are arranged, and may refer to the direction perpendicular to the partition plate 72 in this order. In the present embodiment, the heat radiation fins 74 are illustrated to protrude from one side of the partition plate 72 facing the circuit board 80, but it is not limited thereto. The heat radiation fins 74 may be configured to protrude from the other side of the partition plate 72 facing the power module 84.

A plurality of heat radiation fins 74 may be provided, and may be formed on the partition plate 72 with being spaced apart from each other. The heat radiation fins 74 may be integrally formed with the partition plate 72.

The partition part 70 may include separation spaces 76.

The separation spaces 76 may be defined between the plurality of heat radiation fins 74. The separation spaces 76 may be formed between the circuit board 80 and the power module 84, thereby performing a thermal insulation function due to air. In the present embodiment, through the separation spaces 76, it may be configured so that the heat generated from the circuit board 80 is transferred to the partition part 70 only through the heat radiation fins 74.

The case cover 66 may include a resin material for wireless charging through the power module 84. The case cover 66 may be coupled to the case body 63 so as to cover the power module 84 disposed therein and seal an opening 64 of the case body 63. That is, the case cover 66 may be coupled to the case body 63 so as to cover the second space 61b.

Hereinafter, heat generation of the wireless charging apparatus having the above-described configuration according to the present invention will be described.

An amount of heat generated ('heat generation amount') during the charging process in the wireless charging apparatus 50 may satisfy Equation 1 below. As described above, the case in which the wireless charging apparatus 50 is a power reception apparatus for receiving power will be described.

[Equation 1]

$$Q_h = 0.24 \times P \times t$$

In Equation 1, $Q_h$ is the heat generation amount (kcal), P is a power (W) applied to the wireless charging apparatus 50, and t is a driving time (sec). As used herein, the $Q_h$ may refer to the amounts of heat generated from the power module 84 and the circuit board 80.

Based on this, it is possible to compare the heat generation amount when the charging efficiency is ideally 100% with the heat generation amount when the charging efficiency is realistically lower than 100% due to resistance or external factors.

In the case of having the ideal charging efficiency (hereinafter, Case 1), the heat generation amount may be defined as $Q_{h\_i}$, and in the case of having the realistic charging efficiency (hereinafter, Case 2), that is, the actual heat generation amount may be defined as $Q_{h\_r}$. In the present embodiment, the case in which the charging efficiency of Case 2 is set to be 85% will be described as an example, but it is not limited thereto.

In Cases 1 and 2, a voltage of power generated from the power transmission apparatus may be set to be 48 V. In Cases 1 and 2, the powers transmitted from the power reception apparatus to the battery 30 by the induced current may be set to be the same as each other, and the voltages at the power reception apparatus may be set to be the same 54.6 V as each other. Further, in Cases 1 and 2, the current in the power reception apparatus may be set to be the same 3 A as each other.

In addition, when the charging efficiency of Case 1 is 100%, and when the charging efficiency is 85% as an example of Case 2, input powers transmitted from the power transmission apparatus to the power reception apparatus, an output power from the power reception apparatus, and a heat generation amount in the power reception apparatus for 90 minutes may satisfy Table 1 below, respectively.

[TABLE 1]

|  | Charging efficiency 100% | Charging efficiency 85% |
|---|---|---|
| **Input power (Wi)** | 48V $\times$ 3.412A = 163.8W | 48V $\times$ 4.015A = 192.7W |
| **Output power (Wo)** | 54.6V $\times$ 3A = 163.8W | 54.6V $\times$ 3A = 163.8W |
| **Heat generation amount for 90 min (kcal)** | **212.3 kcal** (0.24 $\times$ 163.8W $\times$ 5400 $\times$ 0.001) | **249.7 kcal** (0.24 $\times$ 192.7W $\times$ 5400 $\times$ 0.001) |

An amount of heat radiated ('heat radiation amount') from the heat radiation module during the charging process may satisfy Equation 2 below.

[Equation 2]

$$Q_c = C \times A \times m \times \Delta T$$

In Equation 2, $Q_C$ is the heat radiation amount (kcal) of the heat radiation module, C is a specific heat (kcal/g · °C) of the heat radiation module, m is a mass (g) of the heat radiation module, and $\Delta T$ is a temperature change (°C) of the heat radiation module. A is a correction factor.

The correction factor A may be set in consideration of surface areas of the external heat radiation fins 68, the heat radiation case 60 exposed to the outside by the case body 63, and the heat radiation module 62, and thicknesses of the heat radiation case 60, and the heat radiation module 62, etc. The correction factor A may be 10 or more and 35 or less. The correction factor A is not limited to an integer.

Based on the above contents, the heat radiation module 62 may satisfy the relationship between the heat generation amounts of the circuit board 80 and the power module 84 as Equation 3 below.

[Equation 3]

$$\frac{Q_{h\_r} - Q_{h\_i}}{C \times \triangle T} < A \times m$$

To control the heating temperature, the mass of the heat radiation module and the correction factor A may be set depending on the set heating temperature as shown in Table 2 below.

[TABLE 2]

| Set heating temperature (ΔT) | Mass (g) and correction factor (A) of heat radiation module |
|---|---|
| 75 | 8.3A |
| 50 | 12.5A |
| 20 | 31.2A |

That is, in the design of the heat radiation case 60, the correction factor A and the mass m may be designed by setting the maximum width of the temperature change in consideration of the actual charging efficiency. Thereby, it is possible to optimally design the heat radiation module of the wireless charging apparatus, and achieve a reduction in weight and an increase in heat radiation efficiency.

Hereinafter, a comparative example regarding the heating temperature over the charging time of the wireless charging apparatus 50 having the heat radiation case 60 of the present invention configured by the above-described design, and the conventional wireless charging apparatus shown in FIG. 1 will be described.

In the heating temperature measurement, the charging frequency was set to be 125 kHz, and the power transmission apparatus was configured by connecting an AC-DC conversion adapter to a 220 V wall outlet. The power transmission apparatus was connected with the AC-DC conversion adapter. An electric load was set to be 54.6 V and 3 A, and was connected with the power reception apparatus. The power reception apparatus was disposed on the power transmission apparatus so that a transmission coil of the power transmission apparatus and a reception coil of the power reception apparatus could be properly aligned. Thereafter, a temperature of the circuit board of the power reception apparatus was measured for a predetermined period of time in real time, and the heating temperature for each charging time was measured.

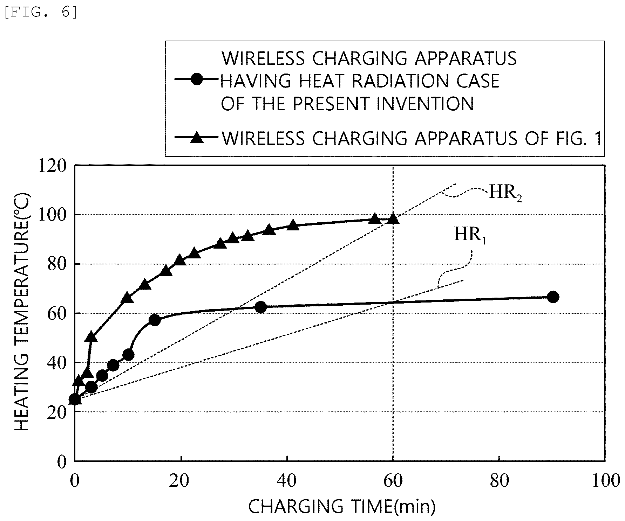

Table 3 below shows values related to the heating temperature over the charging time of the wireless charging apparatus 50 of the present embodiment. Table 4 below shows values related to the heating temperature over the charging time of the conventional wireless charging apparatus 1. A graph relating thereto is as shown in FIG. 6. For reference, as described above, the case in which the wireless charging apparatus 50 is the power reception apparatus will be mainly described.

[TABLE 3]

| Wireless charging apparatus 50 of the present embodiment | Charging time (min) | 0 | 3 | 5 | 7 | 10 | 15 | 35 | 90 |
|---|---|---|---|---|---|---|---|---|---|
| | Heating temperature (°C) | 25 | 30 | 35 | 39 | 43 | 57 | 62 | 67 |

[TABLE 4]

| Conventional wireless charging apparatus 1 | Charging time (min) | 0 | 1 | 3 | 10 | 13 | 22 | 28 | 36 | 41 | 56 | 60 |
|---|---|---|---|---|---|---|---|---|---|---|---|---|
| | Heating temperature (°C) | 25 | 33 | 50 | 66 | 71 | 84 | 88 | 93 | 95 | 98 | 100 |

As described above, in the present invention, it is possible to control the maximum heating temperature set through the configuration and design of the heat radiation module 62.

As shown in Tables 3 and 4 and FIG. 6, after a predetermined period of time elapses, the heating temperatures of the wireless charging apparatus of the present embodiment and the conventional wireless charging apparatus (see FIG. 1) are constantly maintained. In Tables 3 and 4 and FIG. 6, the heating temperatures over the charging time for the wireless charging apparatus of the present embodiment and the conventional wireless charging apparatus were measured and illustrated up to 90 minutes and 60 minutes, respectively, but the heating temperatures over the charging time thereafter are maintained as they are, and therefore will not be illustrated in FIG. 6. That is, from the point at which the amount of heat generated from the circuit board and the power module and the amount of heat radiated to the outside are the same as each other, the heating temperatures can be constantly maintained.

In the present embodiment, the heating temperature of the wireless charging apparatus is maintained as it is from a point in time of about 90 minutes from a time when charging starts ('charging start time'), and an amount of change in the heating temperature for about 90 minutes from the charging start time is about 40 degrees. Whereas, the heating temperature of the conventional wireless charging apparatus is maintained as it is from a point in time of about 60 minutes from the charging start time, and the amount of change in the heating temperature for about 60 minutes from the charging start time is about 75 degrees.

As used herein, the heating rate (HR) may refer to a ratio of the charging time to the amount of change in the heating temperature. The charging time may refer to a time from the charging start time to a specific time.

That is, the heating rate (HR) may satisfy Equation 4 below.

[Equation 4]

Heating rate (HR, ℃/min) = Δ Heating temperature (℃) / 60 min

The heating rate (HR) may refer to a slope of the heating temperature graph to a predetermined charging time. As shown in FIG. 6, the heating rate of the wireless charging apparatus according to the present embodiment may be about 0.67°C/min (heating temperature = 65°C - 25°C, charging time = 60 min, see $HR_1$ in FIG. 6), the heating rate of the conventional wireless charging apparatus may be about 1.25°C/min (heating temperature = 100°C - 25°C, charging time = 60 min, see $HR_2$ in FIG. 6).

The heating rate (HR) of the wireless charging apparatus according to an embodiment of the present invention may be greater than 0 and less than 2.0, 0.3 or more and 1.6 or less, 0.5 or more and 1.4 or less, and 0.6 or more and 1.3 or less.

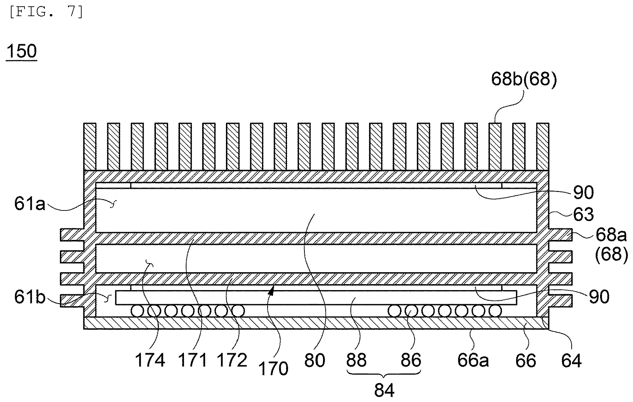

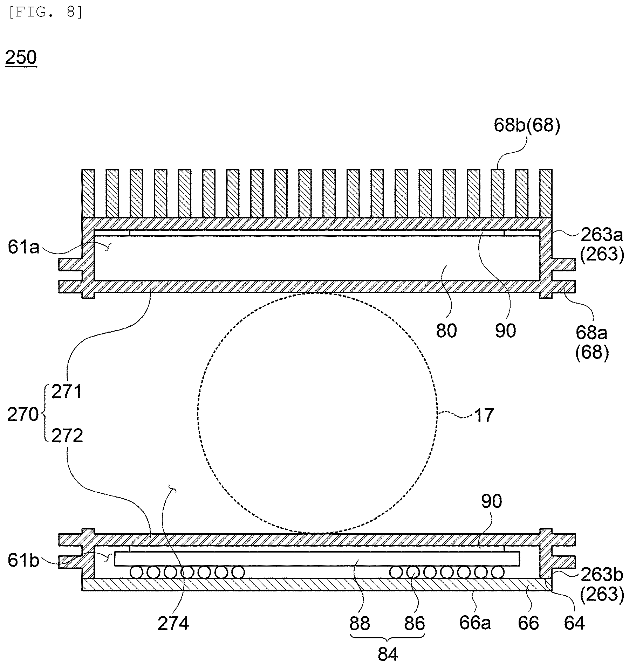

In the heating rate (HR) according to Equation 4 above, 60 min means a time when the wireless charging apparatus is charged, and Δ heating temperature means the temperature change when the wireless charging apparatus is charged for 60 minutes. That is, the slope of $HR_1$ in FIG. 6 may satisfy the numerical range for the heating rate (HR) as described above. For the convenience of description, the wireless charging apparatuses shown in FIGS. 4 and 5 have been described as an example, but the range of the heat generation rate (HR) may be equally applied to the heating rate (HR) of the wireless charging apparatuses shown in FIGS. 7 and 8 which will be described below.

When the heating temperature is rapidly increased, it may cause damage to internal components of the wireless charging apparatus such as a circuit board and a power module, as well as the life-span of the wireless charging apparatus may be shortened, and battery charging efficiency may be reduced. In the present invention, by controlling the amount of change in the heating temperature over the charging time, it is possible to improve the heat radiation efficiency of the wireless charging apparatus.

In addition, by improving the heat radiation efficiency of the wireless charging apparatus, a separate cooling member is not required, such that the wireless charging apparatus may be configured more compactly. Furthermore, since the heat radiation module itself has the functions of housing and cooling the internal components, it is possible to improve the sealing properties and sealing efficiency of the wireless charging apparatus.

Hereinafter, a wireless charging apparatus according to another embodiment of the present invention will be described. In the following description, the same configuration as in the above-described embodiment will not be repeatedly described while denoting by the same reference numerals.

FIG. 7 is a cross-sectional view of a wireless charging apparatus according to another embodiment of the present invention.

A wireless charging apparatus 150 may include a heat radiation module 62.

The heat radiation module 62 may include a partition part 170. The partition part 170 may be disposed inside the case body 63, and may be configured to partition a space formed inside the case body 63. The partition part 170 is one component of the heat radiation module 62, may be made of a heat radiation material, and may include an aluminum material, for example. The partition part 170 may be configured to transfer the heat received from the circuit board 80 or the power module 84 to the case body 63.

The partition part 170 may be configured to partition the inside of the case body 63 so as to prevent the heat generated from the circuit board 80 and the power module 84 from being transferred therebetween. The partition part 170 may be integrally formed with the case body 63 so that the partition part 170 allows the received heat to be transferred to the case body 63.

The partition part 170 may include first and second partition plates 171 and 172.

The first and second partition plates 171 and 172 may be configured to partition a first space 61a in which the circuit board 80 is disposed and a second space 61b in which the power module 84 is disposed. The first partition plate 171 may be disposed to face the first space 61a, and the second partition plate 172 may be disposed to face the second space 61b.

In the wireless charging apparatus 150, the case cover 66 having the charging surface 66a formed therein, the power module 84, and the circuit board 80 may be arranged in this order in one direction (e.g., an up-to-down direction in Fig.7), and the first and second partition plates 171 and 172 may be formed in a direction different from the one direction, for example, a vertical direction(e.g., a left-to-right direction in Fig.7), to partition the power module 84 and the circuit board 80.

The partition plates 171 and 172 may be connected to the inner surface of the case body 63 along the inner circumference thereof. Thereby, it is possible to prevent convection due to heat from occurring between the first and second spaces 61a and 62a, and control heat radiation in each of the first and second spaces 61a and 62a in which the circuit board 80 and the power module 84 are disposed, respectively.

The first and second partition plates 171 and 172 may be formed to be spaced apart from each other so as to form a separation space 174 therebetween. The first and second partition plates 171 and 172 may be arranged side by side with each other, and may form the separation space 174 therebetween.

As the separation space 174 is disposed between the first and second partition plates 171 and 172, the separation space 174 may perform a thermal insulation function due to air. Thereby, the insulation function between the first and second partition plates 171 and 172, and between the circuit board 80 and the power module 84 may be performed.

Through the first and second partition plates 171 and 172 and the separation space 174 in the present embodiment, the heat generated from the circuit board 80 and the power module 84 is transmitted to the heat radiation module 62 and the case body 63 through the first and second partition plates 171 and 172. In addition, through the first and second partition plates 171 and 172, it is possible to prevent the heat generated from the circuit board 80 from being transmitted to the power module 84, or prevent the heat generated from the power module 84 from being transmitted to the circuit board 80.

Hereinafter, a wireless charging module according to another embodiment of the present invention will be described. In the following description, the same configuration as in the above-described embodiment will not be repeatedly described while denoting by the same reference numerals.

FIG. 8 is a cross-sectional view of a wireless charging apparatus according to another embodiment of the present invention.

A wireless charging apparatus 250 may include a heat radiation module 62.

The heat radiation module 62 may include a case body 263. The case body 263 may include first and second case bodies 263a and 263b. The first and second case bodies 63 may be disposed to be spaced apart from each other, thereby it is possible to control heat radiation in each of the first and second spaces 61a and 62a in which the circuit board 80 and the power module 84 are disposed, respectively.

The first case body 263a may form a first space 61a in which the circuit board 80 is disposed, and the second case body 263b may form a second space 61b in which the power module 84 is disposed. The circuit board 80 and the power module 84 respectively disposed in the first and second case bodies 263a and 263b may be electrically connected with each other through a separate wire.

The heat radiation module 62 may include a partition part 270. The partition part 270 may be formed as one component of the case body 263. The partition part 270 is one component of the heat radiation module 62, may be made of a heat radiation material, and may include an aluminum material, for example. In the present embodiment, the partition part 270 is one component of the case body 263 and is configured to be exposed to an outside, such that the partition part 270 may transfer the heat received from the circuit board 80 or the power module 84 to the case body 63 or radiate the heat to the outside.

The partition part 270 may include first and second partition plates 271 and 272.

The first partition plate 271 may be configured to form a first space 61a together with the first case body 263a, and the second partition plate 272 may be configured to form a second space 61b together with the second case body 263b. The steering tube 17 of the electric vehicle may be disposed between the first and second partition plates 271 and 272.

In the wireless charging apparatus 250, the case cover 66 having the charging surface 66a formed therein, the power module 84, and the circuit board 80 may be arranged in this order in one direction (e.g., an up-to-down direction in Fig.8), and the first and second partition plates 271 and 272 may be formed in a direction different from the one direction, for example, a vertical direction (e.g., a left-to-right direction in Fig.8), to partition the power module 84 and the circuit board 80.

The first and second partition plates 271 and 272 may be formed to be spaced apart from each other so as to form a separation space 274 therebetween. The first and second partition plates 271 and 272 may be disposed side by side with each other, and may form the separation space 274 therebetween. The steering tube 17 of the electric vehicle may be disposed in the separation space 274.

As the separation space 274 is disposed between the first and second partition plates 271 and 272, the first and second spaces 61a and 61b may be separated from each other, and mutual influence between the first and second partition plates 271 and 272, and between the circuit board 80 and the power module 84 may be minimized.

As such, specific embodiments of the present invention have been illustrated and described in detail. However, the present invention is not limited to the above embodiments, and it will be understood by those skilled in the art that various alterations and modifications may be implemented without departing from technical spirits of the invention described in the following claims.

[Description of Reference Numerals]

10: Electric scooter
12: Deck body
14: Steering unit
20: Folding part
30: Battery
50: Wireless charging apparatus
60: Heat radiation case
62: Heat radiation module
63: Case body
66: Case cover
68: External heat radiation fin
70: Partition part
80: Circuit board
84: Power module
86: Coil part
88: Magnetic member
90: Heat transfer member

**Claims**

1.  A wireless charging apparatus comprising:

    a heat radiation module;
    a circuit board disposed in the heat radiation module; and
    a power module which is disposed in the heat radiation module and includes a coil for wireless charging,
    wherein the heat radiation module comprises:

    a case body in which the circuit board and the power module are housed; and
    a partition part formed inside the case body to form a separation space between the circuit board and the power module.

2.  The wireless charging apparatus according to claim 1, wherein the heat radiation module comprises a first space in which the circuit board is disposed, and a second space in which the power module is disposed, wherein the partition part is configured to partition the first and second spaces.

3.  The wireless charging apparatus according to claim 1, wherein the partition part comprises:

a partition plate connected to an inner surface of the case body; and
at least one heat radiation fin protruding from the partition plate to the circuit board or the power module,
wherein the separation space is formed in a direction in which the heat radiation fin protrudes.

4. The wireless charging apparatus according to claim 1, wherein the partition part comprises first and second partition plates connected to an inner surface of the case body and formed to be spaced apart from each other, wherein the separation space is formed between the first partition plate and the second partition plate.

5. The wireless charging apparatus according to claim 1, wherein the case body of the heat radiation module and the partition part are integrally formed with each other.

6. The wireless charging apparatus according to claim 1, wherein the heat radiation module comprises external heat radiation fins extending outwardly from the case body and formed in a radial direction.

7. The wireless charging apparatus according to claim 6, wherein the external heat radiation fins comprise a plurality of mounting heat radiation fins having different protrusion heights from the case body so as to have a shape corresponding to the shape of an installation surface which is mounted on the heat radiation module.

8. An electric vehicle configured to move using electricity as a power source, comprising:

   a wireless charging apparatus; and
   a battery configured to be charged through the wireless charging apparatus,
   the wireless charging apparatus comprises:

   a heat radiation module;
   a circuit board disposed in the heat radiation module; and
   a power module which is disposed in the heat radiation module and includes a coil for wireless charging,
   wherein the heat radiation module comprises:

   a case body in which the circuit board and the power module are housed; and
   a partition part formed inside the case body to form a separation space between the circuit board and the power module.

9. A wireless charging apparatus comprising:

   a heat radiation module;
   a circuit board disposed in the heat radiation module; and
   a power module which is disposed in the heat radiation module and includes a coil for wireless charging,
   wherein a heating rate (HR, °C/min) expressed by Equation below is greater than 0 and less than 2.0:

   $$\text{Heating rate (HR)} = \triangle \text{ Heating temperature (}°C\text{)} / 60 \text{ min}$$

   (In the above equation, the 60 min is a time for which the wireless charging apparatus is charged, and the $\triangle$ heating temperature means a temperature change when the wireless charging apparatus is charged for 60 minutes).

10. The wireless charging apparatus according to claim 9, wherein the heat radiation module comprises:

    a case body in which the circuit board and the power module are housed; and
    a partition part formed inside the case body to form a separation space between the circuit board and the power module.

[FIG. 1]

<u>1</u>

[FIG. 2]

<u>10</u>

[FIG. 3]

<u>10</u>

[FIG. 4]

[FIG. 5]

[FIG. 6]

[FIG. 7]

150

[FIG. 8]

<u>250</u>

| **INTERNATIONAL SEARCH REPORT** | International application No.<br>**PCT/KR2022/002575** |
|---|---|

| **A.** | **CLASSIFICATION OF SUBJECT MATTER** |
|---|---|

**H02J 50/00**(2016.01)i; **H02J 50/20**(2016.01)i; **H02J 50/12**(2016.01)i; **H05K 7/20**(2006.01)i; **B60L 53/12**(2019.01)i

According to International Patent Classification (IPC) or to both national classification and IPC

| **B.** | **FIELDS SEARCHED** |
|---|---|

Minimum documentation searched (classification system followed by classification symbols)

H02J 50/00(2016.01); B62K 15/00(2006.01); H01Q 1/02(2006.01); H02J 17/00(2006.01); H02J 50/10(2016.01); H02J 7/02(2006.01); H05K 7/20(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 무선충전(wireless charging), 전기이동장치(electrical vehicle), 배터리(battery), 방열(heat radiation), 이격 공간(separation space)

| **C.** | **DOCUMENTS CONSIDERED TO BE RELEVANT** |
|---|---|

| Category* | Citation of document, with indication, where appropriate, of the relevant passages | Relevant to claim No. |
|---|---|---|
| Y | KR 10-1757204 B1 (SL CORPORATION) 26 July 2017 (2017-07-26)<br>See paragraphs [0050], [0111], [0113], [0117] and [0120]; and figure 5. | 1-10 |
| Y | KR 10-2239517 B1 (KIM, Kyoung Cheol) 12 April 2021 (2021-04-12)<br>See paragraph [0024]; and figure 2. | 1-10 |
| Y | KR 10-2016-0065242 A (DAEJEON UNIVERSITY INDUSTRY-UNIVERSITY COOPERATION FOUNDATION) 09 June 2016 (2016-06-09)<br>See claim 1; and figure 1. | 8 |
| Y | 김평준 등. 열 유동해석을 통한 무선충전기 발열 성능 향상에 관한 연구. Journal of the Korea Academia-Industrial cooperation Society (한국산학기술학회논문지). Volume 20, Issue 7, Pages 310-316, 31 July 2019 (KIM, Pyeong-Jun et al. A Study on the Thermal Flow Analysis for Heat Performance Improvement of a Wireless Power Charger.)<br>See page 313, right column and page 315, left column; and figure 12.<br>Retrieved from (http://koreascience.or.kr/article/JAKO201922850163402.page). | 9-10 |

☑ Further documents are listed in the continuation of Box C.     ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
|---|---|
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **03 June 2022** | **07 June 2022** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2019)

EP 4 131 721 A1

**INTERNATIONAL SEARCH REPORT**

International application No.

**PCT/KR2022/002575**

C.    DOCUMENTS CONSIDERED TO BE RELEVANT

| Category* | Citation of document, with indication, where appropriate, of the relevant passages | Relevant to claim No. |
|---|---|---|
| A | US 2018-0132376 A1 (AMOGREENTECH CO., LTD.) 10 May 2018 (2018-05-10)<br>See claims 1-9; and figures 1-13. | 1-10 |

Form PCT/ISA/210 (second sheet) (July 2019)

**INTERNATIONAL SEARCH REPORT**
Information on patent family members

International application No.

**PCT/KR2022/002575**

| Patent document cited in search report | | | Publication date (day/month/year) | Patent family member(s) | | | Publication date (day/month/year) |
|---|---|---|---|---|---|---|---|
| KR | 10-1757204 | B1 | 26 July 2017 | None | | | |
| KR | 10-2239517 | B1 | 12 April 2021 | None | | | |
| KR | 10-2016-0065242 | A | 09 June 2016 | None | | | |
| US | 2018-0132376 | A1 | 10 May 2018 | CN | 107371387 | A | 21 November 2017 |
| | | | | CN | 107371387 | B | 01 October 2021 |
| | | | | KR | 10-1629653 | B1 | 13 June 2016 |
| | | | | KR | 10-2016-0118911 | A | 12 October 2016 |
| | | | | US | 10334752 | B2 | 25 June 2019 |
| | | | | WO | 2016-159551 | A1 | 06 October 2016 |

Form PCT/ISA/210 (patent family annex) (July 2019)